## Europäisches Patentamt

## European Patent Office

## Office européen des brevets

(19)

(11) Veröffentlichungsnummer: **0 242 707**
**A1**

(12) **EUROPÄISCHE PATENTANMELDUNG**

(21) Anmeldenummer: **87105184.3**

(22) Anmeldetag: **08.04.87**

(51) Int. Cl.⁴: **G01R 31/32**

(30) Priorität: **22.04.86 CH 1626/86**

(43) Veröffentlichungstag der Anmeldung:
**28.10.87 Patentblatt 87/44**

(84) Benannte Vertragsstaaten:
**CH DE IT LI NL SE**

(71) Anmelder: **BBC Brown Boveri AG**

**CH-5401 Baden(CH)**

(72) Erfinder: **Fröhlich, Klaus, Dr.**
**Baldeggstrasse 11**
**CH-5400 Baden(CH)**
Erfinder: **Widenhorn, Leonhard**
**Haldenstrasse 29**
**CH-8955 Oetwil(CH)**

(54) **Prüfkreis.**

(57) Der Prüfkreis für die synthetische Prüfung von Hochspannungs-Gleichstromschaltern enthält eine Reihenschaltung von mindestens einer Energiequelle mit mindestens einer Induktivität (30) und einem Prüfschalter (31).

Dieser Prüfkreis soll mit einer leistungsstarken Energiequelle versehen werden, welche den Nachweis hoher Abschaltleistungen erlaubt. Ferner soll es möglich sein, mit diesem Prüfkreis transiente Verläufe des abzuschaltenden Gleichstromes nachzubilden. Dies wird dadurch erreicht, dass die mindestens eine Energiequelle eine Wechselspannungsquelle enthält, der mindestens ein Gleichrichter (14; 24) nachgeschaltet ist. Mittels gesteuert zu-und abschaltbarer ohmscher Widerstände ($R_{11}$ ... $R_{1n}$; $R_{21}$... $R_{2n}$) wird hierbei eine fallende bzw. ansteigende Charakteristik des abzuschaltenden Gleichstromes erzielt.

EP 0 242 707 A1

FIG.1

## Prüfkreis

Die Erfindung geht aus von einem Prüfkreis gemäss dem ersten Teil des Anspruchs 1.

Aus der Schrift von M. Sakai, Y. Kato, S. Tokuyama, H. Suguwara und K. Arimatsu mit dem Titel: "Development and Field application of metallic return protecting breaker for HVDC-Transmission" (IEEE Transaction on Power Apparatus and Systems, 81 SM 472-0) ist ein Prüfkreis für die synthetische Prüfung von Gleichstromschaltern bekannt. Dieser Prüfkreis weist als Energiequelle eine geladene Kondensatorbatterie auf, welche mittels eines Einschaltgerätes in Reihe zu einer Induktivität geschaltet werden kann. Nach dem Betätigen des Einschaltgerätes fliesst ein von der Kondensatorbatterie gespeister Schwingstrom und lädt die Induktivität auf. Unmittelbar nach dem Erreichen des maximalen Ladestromes wird die Kondensatorbatterie mittels eines Kurzschliessers kurzgeschlossen. Dieser Kurzschliesser überbrückt gleichzeitig die Induktivität und einen zu ihr in Reihe geschalteten Prüfschalter. Die in der aufgeladenen Induktivität gespeicherte Energie treibt nun einen Gleichstrom durch die Reihenschaltung von Prüfschalter und Kurzschliesser, welcher vom Prüfschalter in bekannter Weise unterbrochen werden kann. Nach einer erfolgreichen Abschaltung wird die wiederkehrende Spannung über den Prüfschalter von der in der Induktivität gespeicherten Energie aufgebaut.

Dieser Prüfkreis ist jedoch nur für vergleichsweise kleine Gleichströme und Abschaltleistungen geeignet, da Kondensatorbatterien mit wirtschaftlich vertretbarem Aufwand nur vergleicheise kleine Energiemengen speichern können. Ferner ist es mit diesem Prüfkreis nicht möglich Gleichströme mit einem transienten Stromanteil zu erzeugen. Ebenso kann der Prüfschalter bei einem Schaltversager nicht vor Sekundärschäden geschützt werden.

Hier will die Erfindung Abhilfe schaffen. Die Erfindung, wie sie in den Ansprüchen gekennzeichnet ist, löst die Aufgabe einen Prüfkreis für die synthetische Prüfung von Hochspannungs-Gleichstromschaltern zu schaffen, welcher eine leistungsstärkere Energiequelle aufweist, welcher den Nachweis von wesentlich höheren Abschaltleistungen zulässt und welcher die Nachbildung transienter Verläufe des abzuschaltenden Gleichstromes erlaubt.

Der Vorteil der Erfindung ist im wesentlichen darin zu sehen, dass sie mit vergleichsweise einfachen, in Hochleistungsprüfanlagen vorhandenen Mitteln realisiert werden kann. Ferner ist es vorteilhaft, dass der zu prüfende Hochspannungs-Gleichstromschalter im Falle eines Schaltversagens vor Sekundärschäden geschützt werden kann.

Die weiteren Ausgestaltungen der Erfindung sind Gegenstände der abhängigen Ansprüche.

Nachfolgend wird die Erfindung anhand von Zeichnungen näher erläutert.

Es zeigt:

Fig. 1 eine erste Ausführungsform des erfindungsgemässen Prüfkreises,

Fig. 2 eine zweite Ausführungsform des erfindungsgemässen Prüfkreises,

Fig. 3 eine dritte Ausführungsform des erfindungsgemässen Prüfkreises,

Fig. 4 eine vereinfachte Darstellung des mit dem erfindungsgemässen Prüfkreis gemäss Fig. 1 möglichen transienten Gleichstromverlaufes, und

Fig. 5 eine vierte Ausführungsform des erfindungsgemässen Prüfkreises.

Bei allen Figuren sind gleich wirkende Elemente mit gleichen Bezugszeichen versehen.

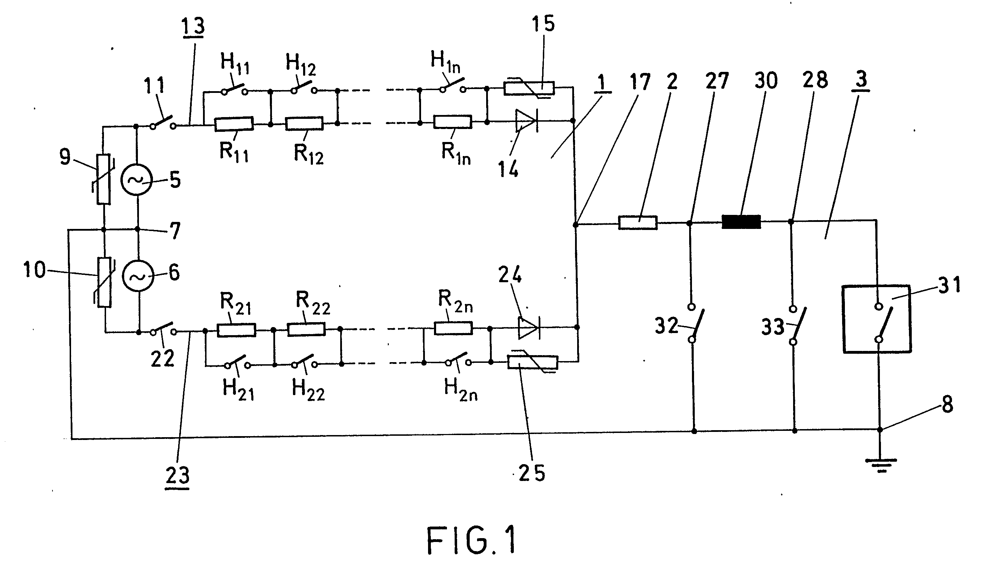

In der Fig. 1 ist ein erfindungsgemässer Prüfkreis dargestellt, welcher sich aus einem als Energiequelle dienenden Ladekreis 1 mit nachgeschaltetem Ladewiderstand 2 und einem Induktivitätskreis 3 zuammensetzt. Der Ladekreis 1 wird gespeist von zwei in der Regel gleichen Wechselstromgeneratoren 5, 6, beispielsweise Kurzschlussgeneratoren, die einseitig miteinander verbunden sind, wobei deren wie eine Mittenanzapfung wirkende Verbindungsstelle 7 mit einer Erdklemme 8 in Verbindung steht. Parallel zu den Wechselstromgeneratoren 5, 6 liegt jeweils ein Ueberspannungsableiter 9, 10, vorzugsweise ein MO-Ableiter. Der Wechselstromgenerator 5 speist über einen Sicherheits schalter 11 einen Zweig 13 des Ladekreises 1. Dieser Zweig 13 weist eine Reihenschaltung von ohmschen Widerständen $R_1$, bis $R_{1n}$ auf. Zu jedem dieser ohmschen Widerstände $R_1$ bis $R_{1n}$ ist eine Hilfseinrichtung $H_1$, bis $H_{1n}$ parallel geschaltet, welche den jeweilig zugeordneten Widerstand kurzschliessen und ihn auch wieder in den Zweig 13 einschalten kann. Die Hilfseinrichtungen $H_1$, bis $H_{1n}$ können Hochspannungs-Wechselstromschalter oder Hochspannungstrennschalter sein. Nach dem ohmschen Widerstand $R_{1n}$ liegt im Zweig 13 eine Gleichrichteranordnung 14 und parallel zu dieser eine Ueberspannungsableiteranordnung 15. Die Gleichrichteranordnung 14 ist vorzugsweise aus mehreren Dioden in Reihen-und Parallelschaltung entsprechend den vorgegebenen Spannungs-und Strombelastungen aufgebaut. Zu jeder dieser Dioden ist ein entsprechender separater Ueberspannungsableiter der Ueberspannungsableiteranordnung 15, vorzugsweise ein MO-Ableiter, parallelgeschaltet. Der Ausgang des Zweiges 13 ist mit einer Klemme 17 verbunden.

Der Wechselstromgenerator 6 speist über einen Sicherheitsschalter 22 einen Zweig 23 des Ladekreises 1. Der Zweig 23 weist, ähnlich wie der Zweig 13, eine Reihenschaltung von ohmschen Widerständen $R_{21}$ bis $R_{2n}$ und dazu parallelen Hilfseinrichtungen $H_{21}$ bis $H_{2n}$ auf, welche ebenfalls zum Zu-und Abschalten der entsprechenden ohmschen Widerstände dienen. Ferner liegt im Zweig 23 nach dem Widerstand $R_{2n}$ eine Gleichrichteranordnung 24 und dazu parallel eine Ueberspannungsableiteranordnung 25. Der Ausgang des Zweiges 23 ist ebenfalls mit der Klemme 17 verbunden. Die Gleichrichteranordnungen 14 und 24 sind gleich aufgebaut, ebenso die Ueberspannungsableiteranordnungen 15 und 25. Die einander entsprechenden ohmschen Widerstände der beiden Zweige 13 und 23, beispielsweise $R_{11}$ und $R_{21}$ bzw $R_{1n}$ und $R_{2n}$, weisen jeweils gleiche Widerstandswerte auf. Die Hilfseinrichtungen $H_{21}$ bis $H_{2n}$ sind in der Regel Hoch spannungsleistungsschalter für Wechselspannung mit mehreren Schaltkammern in Reihe. Die beiden Zweige 13 und 23 des Ladekreises 1 sind demnach mit Ausnahme der Hilfseinrichtungen $H_{11}$ bis $H_{1n}$ und $H_{21}$ bis $H_{2n}$ symmetrisch aufgebaut.

Die Klemme 17 ist über den Ladewiderstand 2 mit einer Klemme 27 verbunden, welche als Eingang zum Induktivitätskreis 3 betrachtet werden kann. Zwischen die Klemme 27 und eine Klemme 28 ist eine Induktivität 30 geschaltet, während zwischen der Klemme 28 und der Erdklemme 8 ein Prüfschalter 31 vorgesehen ist. Ueber einen einschaltfesten Kurzschliesser 32 ist die Klemme 27 mit der Erde verbunden. Ein weiterer einschaltfester Kurzschliesser, der als Notschalter 33 dient, stellt die Verbindung zwischen der Klemme 28 und der Erde her, wobei diese Verbindung besonders impedanzarm ausgeführt ist.

Zur Erläuterung der Wirkungsweise dieses Prüfkreises sei Fig. 1 näher betrachtet. Zunächst sind alle Hilfseinrichtungen $H_{11}$ bis $H_{1n}$ und $H_{21}$ bis $H_{2n}$ geschlossen, ebenso der Prüfschalter 31. Die Sicherheitsschalter 11 und 22 sind ebenso offen, wie der Kurzschliesser 32 und der Notschalter 33. Nach dem Schliessen der Sicherheitsschalter 11 und 22 beginnt, von den beiden Wechselstromgeneratoren 5 und 6 gespeist, in jedem der Zweige 13 und 23 wechselweise ein Strom zu fliessen. In den nach dem Prinzip der Zweipuls-Mittelpunktschaltung angeordneten Gleichrichteranordnungen 14 und 24 werden diese Ströme gleichgerichtet und danach zu einem Gleichstrom $i_L(t)$ aufsummiert. Ueber den Ladewiderstand 2, die Induktivität 30, den geschlossenen Prüfschalter 31, die Erdklemme 8 und eine Rückleitung zur Verbindungsstelle 7 der beiden Wechselstromgeneratoren 5 und 6 schliesst sich der Prüfkreis. Der Gleichstrom $i_L(t)$ steigt exponentiell an bis zu einem Maximalwert, der im Bereich um 10 kA liegen kann. Sollten höhere Stromwerte verlangt werden, so kann durch entsprechendes Anpassen der einzelnen Elemente dieses Prüfkreises der Stromwert beliebig gesteigert werden. Wenn der Maximalwert des Gleichstromes $i_L(t)$ erreicht ist, ist auch die Induktivität 30 maximal mit elektrischer Energie aufgeladen.

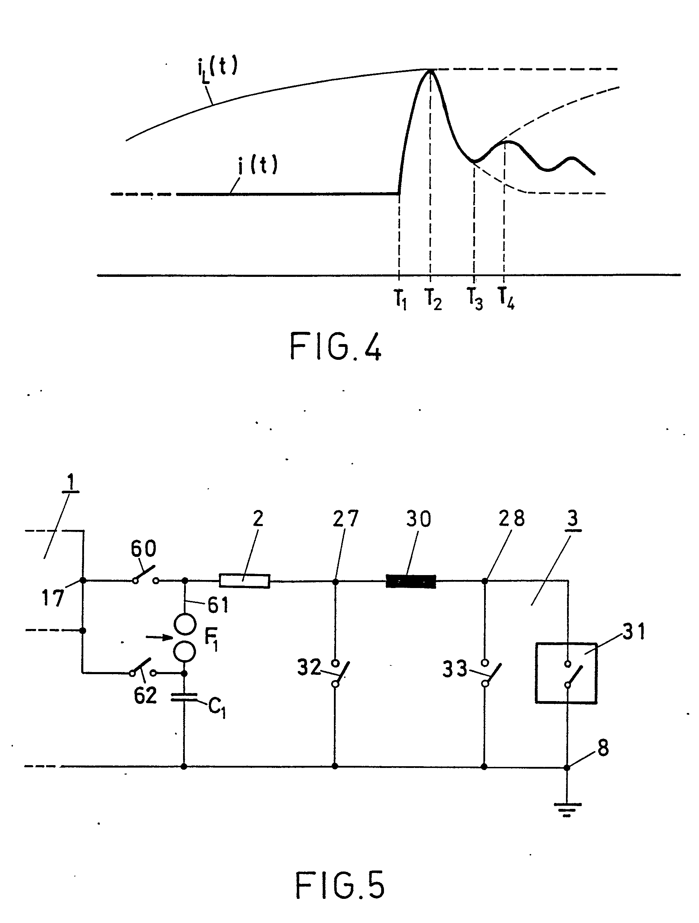

Zur weiteren Erläuterung der Wirkungsweise sei nun zusätzlich die Fig. 4 etwas näher betrachtet. Die Kurve $i(t)$ stellt einen zeitlichen Verlauf eines Gleichstromes in einem typischen Gleichstromnetzwerk dar. Zunächst fliesst ein konstanter Nennbetriebsstrom solange, bis in einem Zeitpunkt $T_1$ ein Fehler auftritt. Der Fehler hat einen transienten Anstieg des Gleichstromes $i(t)$ zur Folge bis in einem Zeitpunkt $T_2$ dessen Strommaximum erreicht wird. Danach sinkt der transiente Gleichstrom $i(t)$ infolge eines regulierenden Einwirkens der das Gleichstromnetzwerk speisenden Ventilstationen wieder ab auf den Wert des Nennbetriebsstromes. Das erfolgt, wie dargestellt, in Form einer gedämpften Schwingung.

Um eine fallende Charakterisitk des Gleichstroms $i_L(t)$ zu erreichen, werden ohmsche Widerstände zusätzlich zum Ladewiderstand 2 in den Prüfkreis geschaltet. Je höher der zugeschaltete Widerstandswert ist, desto steiler fällt der Gleichstrom $i_L(t)$ ab. Die beiden Zweige 13 und 23 führen wechselweise Strom. Das Zuschalten der Widerstände wird nun stets von einer nicht dargestellten, entsprechend den gewünschten Prüfbedingungen vorprogrammierten zentralen Steuereinheit so eingeleitet, dass zunächst in der stromlosen Phase des Zweiges 13 in diesem Zweig 13 beispielsweise alle Hilfseinrichtungen $H_{11}$ bis $H_{1n}$ geöffnet werden. Dieses Oeffnen erfolgt stromlos, so dass an das Abschaltvermögen dieser Hilfseinrichtungen nur geringe Anforderungen gestellt werden müssen. Im Zweig 13 sind damit alle Widerstände $R_{11}$ bis $R_{1n}$ eingeschaltet.

Der gleiche Vorgang sollte nun in der theoretisch nachfolgenden stromlosen Phase des Zweiges 23, während der der Zweig 13 den Strom führen sollte, in diesem Zweig 23 erfolgen. Die Induktivität 30 saugt jedoch weiter Strom aus dem Zweig 23 und verhindert so einen Stromnulldurchgang in diesem Zweig 23. Aus diesem Grunde sind als Hilfseinrichtungen $H_{21}$ bis $H_{2n}$ im Zweig 23 Hochspannungs-Leistungsschalter mit mehreren Schaltkammern in Reihe nötig. Diese Hilfseinrichtungen $H_{21}$ bis $H_{2n}$ werden stets nach dem Oeffnen der Hilfseinrichtungen $H_{11}$ bis $H_{1n}$ im Zweig 13

angesteuert und unter Strom geöffnet, so dass Schaltlichtbögen entstehen. Dabei wird eine so hohe Lichtbogenspannung über jeder der Hilfseinrichtungen $H_{21}$ bis $H_{2n}$ erzeugt, dass das Kommutieren des Stromes in den Zweig 13 und zum Teil in die Widerstände des Zweiges 23 erzwungen wird. Nach dieser Kommutation erlöschen die Schaltlichtbögen und die Widerstände $R_{11}$ bis $R_{1n}$ und $R_{21}$ bis $R_{2n}$ sind voll wirksam. Der Ladekreis 1 ist jetzt wieder symmetrisch aufgebaut und die beiden Zweige 13 und 23 liefern wechselweise ihren Anteil zum Gleichstrom $i_L(t)$. Die Induktivität 30 saugt aber so stark Strom aus dem Ladekreis 1, dass der Gleichstrom $i_L(t)$ erst allmählich auf einen entsprechend der neuen Widerstandsbeschaltung tieferen Wert absinken kann. Dieses Absinken kann so eingestellt werden, dass der transiente Verlauf des Gleichstromes i(t) gut nachgebildet wird.

In einem Zeitpunkt $T_3$ kann das Absinken des Gleichstromes $i_L(t)$ unterbrochen werden, indem ein vorbestimmter Teil der zusätzlichen Widerstände, beispielsweise $R_{11}$ und $R_{12}$ im Zweig 13 und $R_{21}$ und $R_{22}$ im Zweig 23, mittels der zugeordneten Hilfseinrichtungen $H_{11}$, $H_{12}$, $H_{21}$ und $H_{22}$ kurzgeschlossen wird. Ein Anstieg des Gleichstromes $i_L(t)$ ergibt sich daraus, der solange andauert, bis in einem Zeitpunkt $T_4$ die erwähnten kurzgeschlossenen Widerstände wieder entsprechend dem bereits beschriebenen Vorgehen in den Prüfkreis eingeschaltet werden und ein erneutes Abklingen des Gleichstromes $i_L(t)$ einleiten. Das beschriebene Zu-und Abschalten kann mehrfach erfolgen, so dass jeder in einem Gleichstromnetz mögliche transiente Stromverlauf nachgebildet werden kann. Es können auch beliebige Widerstandskombinationen zu-und abgeschaltet werden, wenn dabei darauf geachtet wird, dass die Zweige 13 und 23 jeweils symmetrisch beschaltet sind.

Im Zeitpunkt $T_2$ oder danach wird nun der Prüfschalter 31 geöffnet, um dessen Abschaltvermögen im Bereich von Gleichströmen mit überlagertem transienten Anteil zu untersuchen. Es ist ferner jederzeit möglich den Kurzschliesser 32 zu schliessen und damit von einem transient verlaufenden Gleichstrom $i_L(t)$ überzugehen auf einen quasi-konstanten Gleichstrom. Der durch den Prüfschalter 31 fliessende quasi-konstante Gleichstrom wird dann durch die Induktivität 30 geliefert. Sollte der Prüfschalter 31 beim Abschalten versagen, so wird der Notschalter 33 eingelegt, welcher den Prüfschalter 31 kurzschliesst und vor Sekundärschäden bewahrt. Der Notschalter 33 kann von der zentralen Steuereinheit bei jedem Versuch automatisch nach einer sinnvoll bemessenen erwarteten Ausschaltzeit des Prüfschalters 31 eingelegt werden, er kann aber auch von einem dem Prüfschalter 31 nachgeschalteten, nicht dargestellten Sensor betätigt werden. Die Strombahn, in welcher der Notschalter 33 liegt, ist besonders impedanzarm ausgebildet, um ein schnelles Kommutieren des Gleichstromes vom Prüfschalter 31 auf diese Strombahn sicherzustellen und so den Prüfschalter 31 optimal zu schützen.

Die Hilfseinrichtungen $H_{11}$ bis $H_{1n}$ und $H_{21}$ bis $H_{2n}$, der Kurzschliesser 32 und der Notschalter 33 sind in der Regel Wechselstromschaltgeräte, welche den besonderen Betriebsbedingungen in diesem Prüfkreis angepasst wurden. Die Wechselstromschaltgeräte sind meist für höhere Ein-und Ausschaltströme ausgelegt als in diesem Prüfkreis auftreten können, deshalb können beispielsweise bei den Hochspannungs-Leistungsschaltern im Zweig 23 die Düsendurchmesser der Schaltkammern verkleinert werden. Werden hier Druckluftschalter eingesetzt, was sich wegen der besonders hohen Lichtbogenspannung bei diesen Schaltern empfiehlt, so kann mit kleineren Düsendurchmessern der Luftverbrauch wesentlich reduziert und damit die Wirtschaftlichkeit des Prüfkreises erhöht werden.

Nach einer erfolgreichen Abschaltung des Gleichstromes $i_L(t)$ wird die wiederkehrende Spannung von der Induktivität 30 bzw. von der in ihr gespeicherten Energie geliefert. Je nach Auslegung des Prüfkreises können 200 kV oder mehr auftreten. Eine Erhöhung dieses Spannungsniveaus ist jederzeit möglich, wenn die einzelnen Elemente des Prüfkreises entsprechend angepasst und dimensioniert werden.

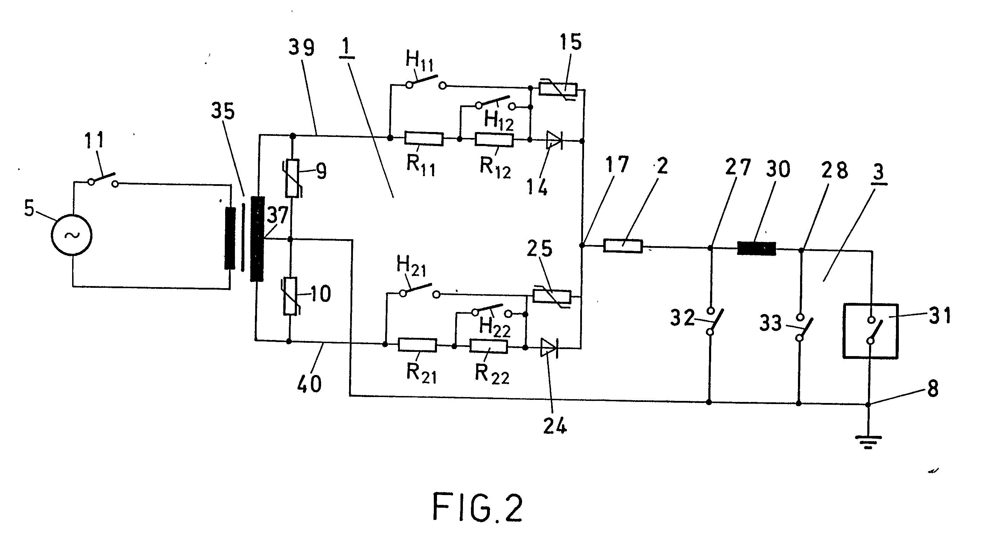

Aus Fig. 2 ist ein weiterer Prüfkreis ersichtlich, der ähnlich aufgebaut ist wie der Prüfkreis nach Fig. 1. Der als Energiequelle dienende Ladekreis 1 wird hier jedoch durch nur einen Wechselstromgenerator 5 und einen Transformator 35 gespeist. Die Oberspannungswicklung dieses Transformators 35 weist eine mit der Erdklemme 8 verbundene Mittenanzapfung 37 auf. Die beiden Teile der Oberspannungswicklung sind mittels der Ueberspannungsableiter 9 und 10 geschützt. Der Ladekreis 1 weist zwei symmetrisch aufgebaute Zweige 39 und 40 auf, mit jeweils nur zwei dargestellten zuschaltbaren Widerständen $R_{11}$, $R_{12}$ und $R_{21}$, $R_{22}$, wobei auch deren Anzahl erweitert werden kann. Eine Hilfseinrichtung $H_{11}$ kann sämtliche Widerstände im Zweig 39 überbrücken, eine weitere Hilfseinrichtung $H_{12}$ kann sämtliche Widerstände ausser $R_{11}$ überbrücken, usw.. Der Zweig 40 ist ähnlich wie der Zweig 39 geschaltet. Der übrige Aufbau des Prüfkreises ist identisch mit dem Prüfkreis nach Fig. 1, auch ist die Wirkungsweise der beiden Prüfkreise gleich.

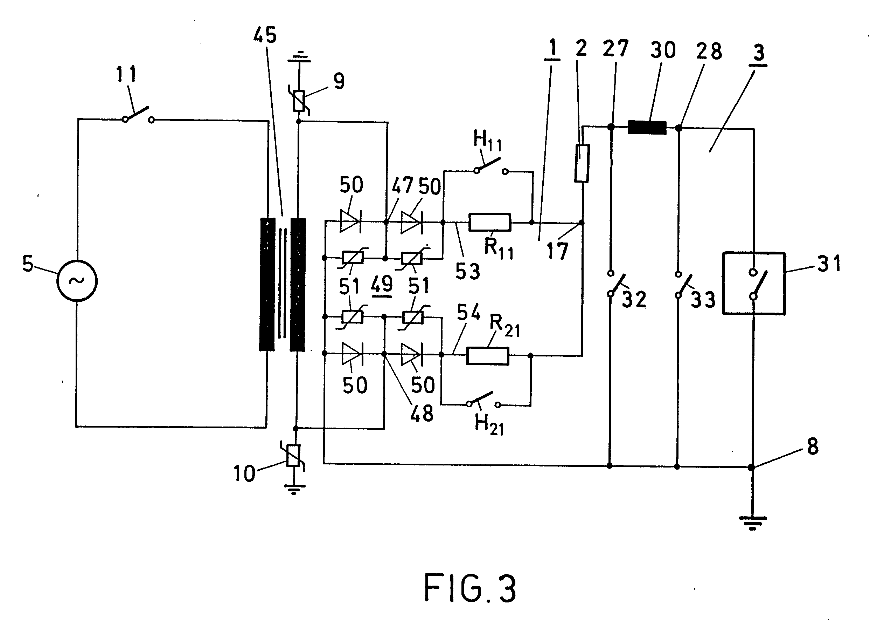

In Fig. 3 ist ein Prüfkreis dargestellt, bei welchem der als Energiequelle dienende Ladekreis 1 durch einen Transformator 45 ohne Mittenanzapfung der Oberspannungswicklung gespeist wird. Die beiden Enden der Oberspannungswicklung werden durch Ueberspannungableiter 9, 10 gegen zu hohes Potential geschützt und sind mit Eingangsklemmen 47 und 48 einer nach dem Prinzip der Graetz-Schaltung arbeitenden Gleichrichter-Brückenschaltung 49 verbunden. Diese Brückenschaltung 49 weist Diodenanordnungen 50 und parallel zu diesen Ueberspannungsableiteranordnungen 51 auf, wobei hier jede der Diodenanordnungen 50 aus mehreren in Reihe und parallel geschalteten Einzeldioden besteht mit jeweils einem separaten Ueberspannungsableiter der Ueberspannungsableiteranordnungen 51 pro Einzeldiode. Ein Ausgang der Gleichrichter-Brückenschaltung 49 ist verbunden mit der Erdklemme 8, der andere Ausgang speist zwei Zweige 53 und 54 des Ladekreises 1, die sich in der Klemme 17 vereinigen. Im Zweig 53 liegt ein ohmscher Widerstand $R_{11}$ der durch eine Hilfseinrichtung $H_{11}$ überbrückt werden kann, im Zweig 54 ein Widerstand $R_{21}$, der durch eine Hilfseinrichtung $H_{21}$ überbrückt werden kann. Es ist jederzeit möglich weitere Widerstände und weitere Hilfseinrichtungen in den Zweigen 53 und 54 vorzusehen. Der weitere Aufbau entspricht dem der in Fig. 1 und Fig. 2 gezeigten Prüfkreise. Dieser Prüfkreis wirkt ähnlich wie der Prüfkreis entsprechend Fig. 1, nur dass eben jeweils nur ein Widerstand $R_{11}$ bzw $R_{21}$ in den Zweigen 53 bzw. 54 zu-bzw. abgeschaltet werden kann, so dass der gewünschte transiente Verlauf des Gleichstromes i-(t) vergleichsweise grob angenähert werden kann. Für die meisten der zu untersuchenden Schaltfälle genügt jedoch diese Annäherung vollauf. Auf diese Art gelingt es einen Prüfkreis zu schaffen, der vom Materialaufwand und vom Platzbedarf her in heute bestehenden Prüfanlagen realisiert werden kann.

Fig. 5 zeigt einen Teil eines erfindungsgemässen Prüfkreises, bei dem zwischen dem als Energiequelle dienenden Ladekreis 1 und dem Induktivitätskreis 3 weitere Elemente zwischengeschaltet sind. Zwischen der Klemme 17 und dem Ladewiderstand 2 wird ein Draufschalter 60 vorgesehen, wobei auf der dem Ladewiderstand 2 zugewandten Seite des Draufschalters 60 eine Strombahn 61 abzweigt. In dieser Strombahn 61 liegt eine Funkenstrecke $F_1$, die von der nicht dargestellten zentralen Steuereinheit her zeitgenau ausgelöst werden kann. In Reihe zu dieser Funkenstrecke $F_1$ ist ferner eine einseitig geerdete Kondensatorbatterie $C_1$ geschaltet, welche von der Klemme 17 her aufgeladen werden kann. Durch einen Schalter 62 kann die geladene Kondensatorbatterie $C_1$ von der Klemme 17 getrennt werden. Danach schliesst der Draufschalter 60 den Prüfkreis und die Induktivität 30 wird aufgeladen, wie bereits früher beschrieben. Sobald der maximale, vom Ladekreis gelieferte Gleichstrom $i_L(t)$ fliesst, kann die Funkenstrecke $F_1$ gezündet werden und die in der Kondensatorbatterie $C_1$ gespeicherte Energie liefert einen transienten, dem Gleichstrom $i_L(t)$ überlagerten Stromanteil. Wird die Funkenstrecke $F_1$ beispielsweise im Zeitpunkt $T_3$ gezündet, so wird der Anstieg des Gleichstromes $i_L(t)$ bis zum Zeitpunkt $T_4$ steiler gestaltet. Dies erlaubt eine gezielte Steuerung der Anstiegscharakteristik, so dass eine grosse Anzahl Varianten des transienten Verlaufes des Gleichstromes $i_L(t)$ nachgebildet werden kann.

Besonders vorteilhaft wirkt es sich aus, wenn die ohmschen Widerstände $R_{11}$ bis $R_{1n}$ und $R_{21}$ bis $R_{2n}$ ganz oder teilweise durch entsprechende nichtlineare Widerstände insbesondere Kaltleiterwiderstände ersetzt werden.

## BEZEICHNUNGSLISTE

- 1 Ladekreis
  2 Ladewiderstand
  3 Induktivitätskreis
  5, 6 Wechselstromgenerator
  7 Verbindungsstelle
  8 Erdklemme
  9, 10 Ueberspannungsableiter
  11 Sicherheitsschalter
  13 Zweig
  14 Gleichrichteranordnung
  15 Ueberspannungsableiteranordnung
  17 Klemme
  22 Sicherheitsschalter
  23 Zweig
  24 Gleichrichteranordnung
  25 Ueberspannungsableiteranordnung
  27, 28 Klemmen
  30 Induktivität
  31 Prüfschalter
  32 Kurzschliesser
  33 Notschalter
  35 Transformator
  37 Mittenanzapfung
  39, 40 Zweig
  45 Transformator
  47, 48 Eingangsklemmen
  49 Brückenschaltung
  50 Diodenanordnung
  51 Ueberspannungsableiteranordnung
  53, 54 Zweige
  60 Draufschalter
  61 Strombahn
  62 Schalter
  $R_{11}$ ... $R_{1n}$, $R_{21}$ ... $R_{2n}$ Widerstände
  $H_{11}$ ... $H_{1n}$, $H_{21}$ ... $H_{2n}$ Hilfseinrichtung
  $i_L(t)$ Gleichstrom
  $i(t)$ Gleichstrom
  $F_1$ Funkenstrecke
  $C_1$ Kondensatorbatterie

## Ansprüche

1. Prüfkreis für die synthetische Prüfung von Hochspannungs-Gleichstromschaltern enthaltend eine Reihenschaltung von mindestens einer ersten Energiequelle mit mindestens einer Induktivität (30) und einem Prüfschalter (31), dadurch gekennzeichnet,

-dass die mindestens eine erste Energiequelle mindestens eine Wechselspannungsquelle enthält, der mindestens ein Gleichrichter nachgeschaltet ist, und

-dass im Prüfkreis mindestens ein gesteuert zu-und abschaltbarer ohmscher Widerstand vorgesehen ist.

2. Prüfkreis nach Anspruch 1, dadurch gekennzeichnet,

-dass mindestens zwei gesteuert zu-und abschaltbare ohmsche Widerstände ($R_{11}$ ... $R_{1n}$; $R_{21}$... $R_{2n}$) vor gesehen sind,

-dass die Wechselspannungsquelle eine Mittelpunktanzapfung aufweist, und

-dass der Gleichrichter in Zweipuls-Mittelpunktschaltung geschaltet ist mit zwei Zweigen (13, 23, 39, 40), in denen jeweils mindestens einer der mindestens zwei ohmschen Widerstände ($R_{11}$ ... $R_{1n}$; $R_{21}$ ... $R_{2n}$) angeordnet ist.

3. Prüfkreis nach Anspruch 1, dadurch gekennzeichnet,

-dass mindestens zwei gesteuert zu-und abschaltbare ohmsche Widerstände ($R_{11}$, $R_{21}$) vorgesehen sind,

-dass der Gleichrichter als Brückenschaltung (49) ausgebildet ist, deren einer Ausgang zwei Zweige (53, 54) aufweist, in denen jeweils mindestens einer der mindestens zwei ohmschen Widerstände ($R_{11}$, $R_{21}$) angeordnet ist.

4. Prüfkreis nach Anspruch 2 oder 3, dadurch gekennzeichnet,

-dass zu mindestens einem in einem ersten beider Zweige (13, 39, 53) angeordneten ersten ohmschen Widerstand ($R_{11}$ ... $R_{1n}$) eine erste Hilfseinrichtung ($H_{11}$ ... $H_{1n}$) parallel geschaltet ist, und

-dass zu mindestens einem in einem zweiten beider Zweige (23, 40, 54) angeordneten zweiten ohmschen Widerstand ($R_{21}$ ... $R_{2n}$) eine zweite Hilfseinrichtung ($H_{21}$ ... $H_{2n}$) parallelgeschaltet ist, welche beim Abschalten eine höhere Impedanz aufweist, als der mindestens eine zweite ohmsche Widersland ($R_{21}$ ... $R_{2n}$) und als der mindestens eine erste ohmsche Widerstand ($R_{11}$ ... $R_{1n}$).

5. Prüfkreis nach einem der Ansprüche 1 bis 4, dadurch gekennzeichnet,

-dass parallel zum Prüfschalter (31) eine impedanzarme Strombahn mit einem Notschalter (33) geschaltet ist.

6. Prüfkreis nach einem der Ansprüche 1 bis 5, dadurch gekennzeichnet,

-dass mindestens eine zweite Energiequelle vorgesehen ist, welche gesteuert parallel zur ersten Energiequelle schaltbar ist.

7. Prüfkreis nach Anspruch 6, dadurch gekennzeichnet,

-dass die mindestens eine zweite Energiequelle als Kondensatorbatterie ($C_1$) ausgebildet ist.

FIG.1

FIG.2

FIG. 3

FIG.4

FIG.5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | IEEE TRANSACTIONS ON POWER APPARATUS AND SYSTEMS, Band PAS-103, Nr. 3, März 1984, Seiten 545-552, IEEE, New York, US; T. SENDA et al.: "Development of HVDC circuit breaker based on hybrid interruption scheme" * Seite 545, rechte Spalte, Zeile 58 - Seite 546, linke Spalte, Zeile 60; Figur 1 * | 1 | G 01 R 31/32 |
| | --- | | |
| Y | DE-A-1 913 548 (GENERAL ELECTRIC CO.) * Seite 3, Zeile 16 - Seite 4, Zeile 3; Seite 9, Zeilen 17-25; Figur 1 * | 1 | |
| | --- | | |
| A | DE-B-1 021 479 (LICENTIA PATENTVERWALTUNGS-GmbH) * Spalte 2, Zeilen 29-34; Figuren 1,2 * | 1,6,7 | RECHERCHIERTE SACHGEBIETE (Int. Cl.4) G 01 R H 01 H |
| | --- | | |
| A | US-A-4 305 107 (M. MURANO et al.) * Spalte 1, Zeilen 14-26; Spalte 4, Zeilen 27-45; Figuren 1,5 * | 1 | |
| | ----- | | |

Der vorliegende Recherchenbericht wurde für alle Patentansprüche erstellt

| Recherchenort DEN HAAG | Abschlußdatum der Recherche 05-08-1987 | Prüfer PENZKOFER, B. |
|---|---|---|

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82